# EUROPEAN PATENT SPECIFICATION

(11) **EP 3 598 466 B1**
(45) Date of publication and mention of the grant of the patent: **18.06.2025**
(21) Application number: 18768494.9
(22) Date of filing: 01.03.2018
(51) Int. Cl.: H01G 11/56, H01G 11/84, H01G 4/10, H01G 4/12, H01G 4/33, H01G 9/032, H01G 11/46

(54) **ELECTRICITY STORAGE DEVICE AND METHOD FOR MANUFACTURING SOLID ELECTROLYTE LAYER**
ELEKTRIZITÄTSSPEICHERVORRICHTUNG UND VERFAHREN ZUR HERSTELLUNG EINER FESTELEKTROLYTSCHICHT
DISPOSITIF DE STOCKAGE D'ÉLECTRICITÉ ET PROCÉDÉ POUR FABRIQUER UNE COUCHE D'ÉLECTROLYTE SOLIDE

(30) Priority: 15.03.2017 JP 2017049589
(43) Date of publication of application: 22.01.2020
(73) Proprietor: Kabushiki Kaisha Nihon Micronics, Musashino-shi, Tokyo 180-8508 (JP)
(72) Inventor: TONOKAWA, Takashi, Musashino-shi, Tokyo 180-8508 (JP); TSUNOKUNI, Kazuyuki, Musashino-shi, Tokyo 180-8508 (JP); OGASAWARA, Juri, Musashino-shi, Tokyo 180-8508 (JP); SATO, Yuki, Musashino-shi, Tokyo 180-8508 (JP)
(74) Representative: Samson & Partner Patentanwälte mbB
(86) International application number: PCT/JP2018/007774
(87) International publication number: WO 2018/168494

(56) References cited:
- WO-A1-2016/208116
- WO-A1-2016/208116
- WO-A1-2017/038008
- WO-A1-2017/038008
- WO-A2-2004/004026
- JP-A- 2005 531 922
- JP-A- 2014 154 505
- JP-A- 2014 154 505

## Description

### TECHNICAL FIELD

The embodiments described herein relate to an electricity storage device and a method for manufacturing a solid electrolyte layer.

### BACKGROUND ART

Capacitors have been generally used as a structure in which an insulation layer is sandwiched between electrodes from both sides.

Moreover, there has also been proposed an electricity storage device having a structure in which an n type semiconductor layer, a hydrous porous insulation layer, and a p type semiconductor layer are layered one after another, and electrodes are formed on upper and lower sides thereof.
Patent Literature 1: Japanese Patent Application Laid-Open Publication No. 2015-82445
WO 2016/208116 A1 relates to a method for manufacturing a secondary battery which includes a charging layer that captures electrons by forming energy levels in a band gap by causing a photoexcited structural change in an n-type metal oxide semiconductor coated with an insulating material.
WO 2004/004026 A2 relates to a method for producing quantum batteries from materials which consist of chemically highly dipolar crystals in the form of nanometer-sized grains or layers that are embedded in electrically insulating matrix materials or intermediate layers, and are applied to compound foils or fixed flat bases.

### SUMMARY OF INVENTION

### Technical Problem

The embodiments provide an electricity storage device having an increased electricity storage capacity and improved reliability that can be charged without degradation even when a charging voltage is increased, and a method for manufacturing a solid electrolyte layer.

### Solution to Problem

The problem is solved by an electricity storage device according to claim 1. A method for manufacturing an electricity storage device according to claim 1 is claimed in claim 12.

According to the embodiments, there can be provided the electricity storage device having the increased electricity storage capacity and improved reliability that can be charged without degradation even when the charging voltage is increased, and the method for manufacturing the solid electrolyte layer.

### Advantageous Effects of Invention

According to the embodiments, there can be provided the highly reliable secondary battery capable of improving the energy density and increasing the battery characteristics (electricity accumulation capacity).

### BRIEF DESCRIPTION OF THE DRAWINGS

[Fig. 1] (a) A schematic cross-sectional structure diagram showing an electricity storage device according to a comparative example 1, and (b) a charging and discharging characteristic diagram of the electricity storage device according to the comparative example 1.
[Fig. 2] (a) A schematic cross-sectional structure diagram showing an electricity storage device according to a comparative example 2, and (b) a charging and discharging characteristic diagram of the electricity storage device according to the comparative example 2.
[Fig. 3] (a) A schematic cross-sectional structure diagram showing an electricity storage device according to the embodiments, and (b) a charging and discharging characteristic diagram of the electricity storage device according to the embodiments.

### DESCRIPTION OF EMBODIMENTS

Next, the embodiments will be described with reference to drawings. In the description of the following drawings, the identical or similar reference sign is attached to the identical or similar part. However, it should be noted that the drawings are schematic and therefore the relation between thickness and the plane size and the ratio of the thickness differs from an actual thing. Therefore, detailed thickness and size should be determined in consideration of the following explanation. Of course, the part from which the relation and ratio of a mutual size differ also in mutually drawings is included.

Moreover, the embodiments shown hereinafter exemplify the apparatus and method for materializing the technical idea; and the embodiments do not specify the material, shape, structure, placement, etc. of each component part as the following. The embodiments may be changed without departing from the scope of claims.

In explanation of following embodiments, a first conductivity type means an n type and a second conductivity type means a p type opposite to the first conductivity type, for example.

### (Comparative Example 1)

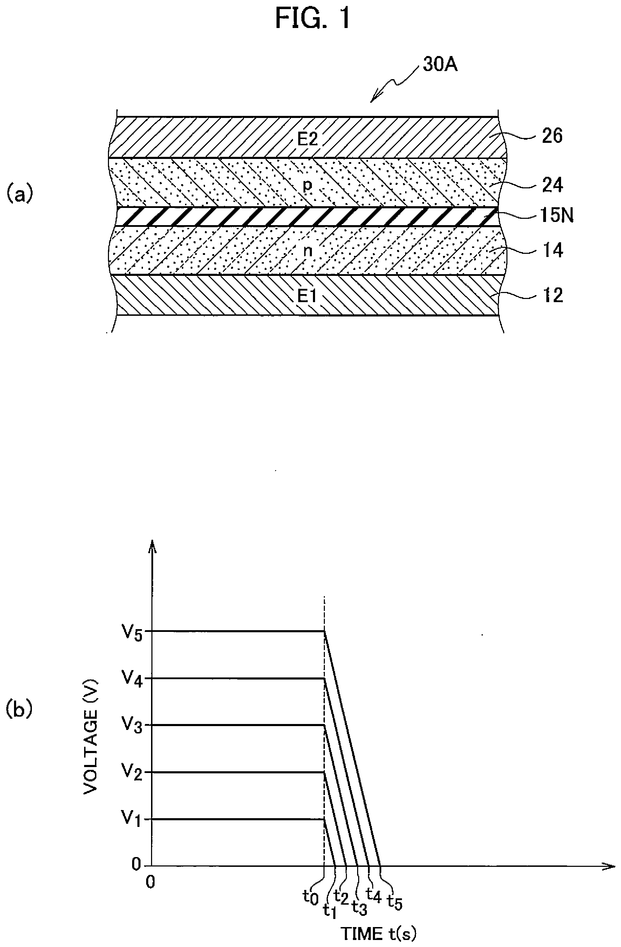

Fig. 1(a) shows a schematic cross-sectional structure showing an electricity storage device 30A according to the comparative example 1, and Fig. 1(b) schematically shows charging and discharging characteristics thereof.

As shown in Fig. 1(a), the electricity storage device 30A according to the comparative example 1 includes, between the first electrode (E1) 12 and the second electrode (E2) 26, a first oxide semiconductor layer 14, an insulator layer 15N disposed on the first oxide semiconductor layer 14, and a second oxide semiconductor layer 24 disposed on the insulator layer 15N.

The insulator layer 15N can be formed by including SiN_{y}, for example.

The second oxide semiconductor layer 24 can be formed by including a nickel oxide (NiO) which is a p type oxide semiconductor.

As shown in Fig. 1(b), for example, in the charging and discharging characteristics of the electricity storage device according to the comparative example 1, with respect to voltages V (V₁ to V₅) at the time of charging, the voltage V₁ is changed to 0V at time t₁ after time t₀, the voltage V₂ is changed to 0V at time t₂, the voltage V₃ is changed to 0V at time t₃, the voltage V₄ is changed to 0V at time t₄, and the voltage V₅ is changed to 0V at time t₅; and then the respective voltages are shifted to a discharged state. More specifically, the charging and discharging characteristics shown in Fig. 1(b) correspond to the charging and discharging characteristics of the capacitor. The discharging characteristics of the electricity storage device according to the comparative example 1 indicate linear characteristics, as shown in Fig. 1(b).

According to the electricity storage device according to the comparative example 1, the capacitor is merely formed if only providing the insulator layer 15N and therefore an amount of electricity storage is also small.

### (Comparative Example 2)

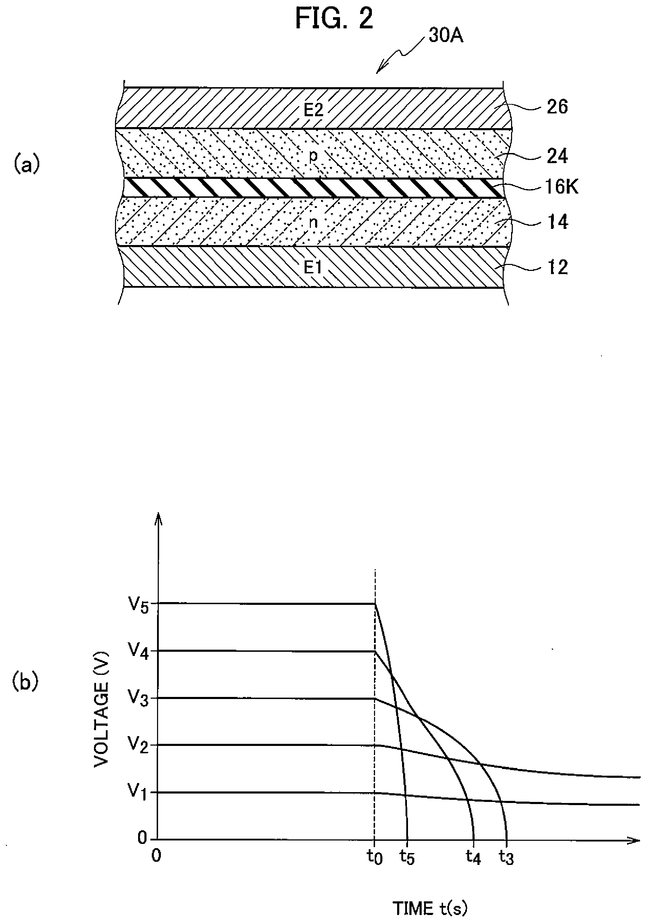

Fig. 2(a) shows a schematic cross-sectional structure showing an electricity storage device 30A according to the comparative example 2, and Fig. 2(b) schematically shows charging and discharging characteristics thereof.

As shown in Fig. 2(a), the electricity storage device 30A according to the comparative example 2 includes, between the first electrode (E1) 12 and the second electrode (E2) 26, a first oxide semiconductor layer 14, a solid electrolyte layer 16K which is disposed on the first oxide semiconductor layer 14 and has a solid electrolyte enabling proton movement, and a second oxide semiconductor layer 24 disposed on the solid electrolyte layer 16K.

The solid electrolyte layer 16K can be formed by including a silicon oxide (SiOₓ), for example. Other configurations thereof are the same as those of the comparative example 1.

As shown in Fig. 2(b), for example, in the charging and discharging characteristics of the electricity storage device according to the comparative example 2, with respect to voltages V (V₁ to V₅) at the time of charging, the voltage V₃ is changed to 0V at time t₃ after time t₀, the voltage V₄ is changed to 0V at time t₄, and the voltage V₅ is changed to 0V at time t₅; and then the respective voltages are shifted to a discharged state. The discharging characteristics of the electricity storage device according to the comparative example 2 indicate decreasing characteristics, as shown in Fig. 2(b).

According to the charging and discharging characteristics of the electricity storage device according to the comparative example 2, an amount of electricity storage larger than the electricity storage device according to the comparative example 1 is obtained even when charging for a long period in a constant current.

The electricity storage device 30A according to the comparative example 1 has small amount of electricity storage since it indicates the capacitor characteristics. However, since the electricity storage device 30A according to the comparative example 2 has a structure in which the solid electrolyte layer 16K contacts the second oxide semiconductor layer 24, as compared with the electricity storage device 30A according to the comparative example 1, it becomes easy to move protons toward the first oxide semiconductor layer 14 from the second oxide semiconductor layer 24 in a voltage applied state in which the second electrode (E2) 26 has high potential with respect to the first electrode (E1) 12. Accordingly, the electricity storage device 30A according to the comparative example 2 can store electricity more than the electricity storage device 30A of the comparative example 1.

Since the electricity storage device 30A according to the comparative example 1 has a structure in which the insulator layer 15N is in contact with the second oxide semiconductor layer 24, it is considered that the proton movement from the second oxide semiconductor layer 24 is interfered by the insulator layer 15N, and therefore movement toward the first oxide semiconductor layer 14 becomes difficult.

However, as shown in Fig. 2(b), in the electricity storage device 30A according to the comparative example 2, since it becomes impossible for the solid electrolyte layer 16K to resist the voltage when the voltage V at the time of charging becomes equal to or greater than V₃ (e.g., approximately 3.0V) also in a leak test, the amount of electricity storage is remarkably reduced.

### (Embodiments)

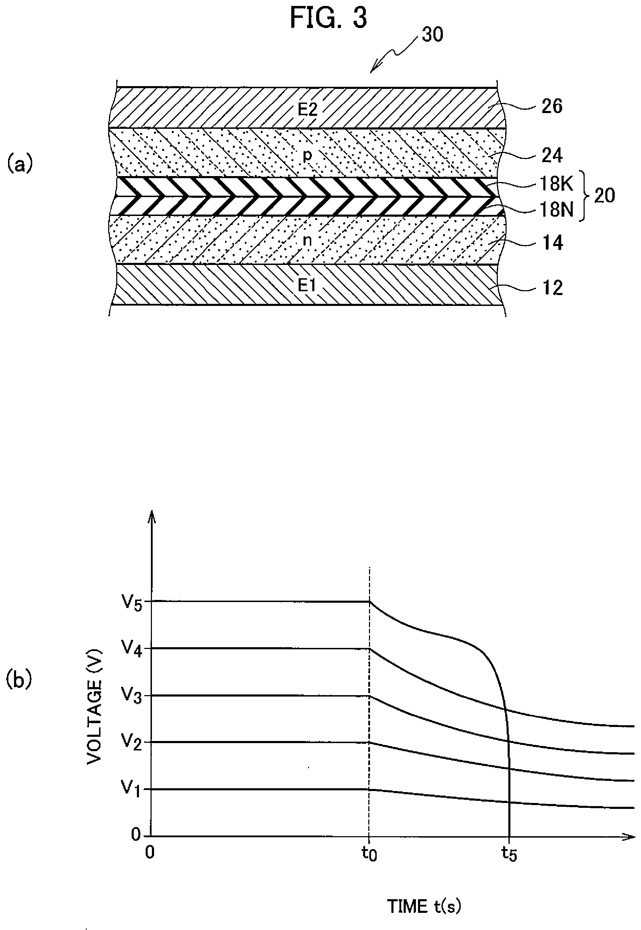

Fig. 3(a) shows a schematic cross-sectional structure of an electricity storage device 30 according to the embodiments, and Fig. 3(b) schematically shows charging and discharging characteristics thereof.

As shown in Fig. 3(a), the electricity storage device 30 according to the embodiments includes, between the first electrode (E1) 12 and the second electrode (E2) 26, a first oxide semiconductor layer 14, a solid electrolyte layer 18K which is disposed on the first oxide semiconductor layer 14 and has a solid electrolyte enabling proton movement, and a second conductivity-type second oxide semiconductor layer 24 disposed on the solid electrolyte layer 18K.

In the embodiments, the first conductivity-type first oxide semiconductor 14 means an oxide semiconductor layer composed by including a first conductivity-type first oxide semiconductor. The second conductivity-type second oxide semiconductor layer 24 means an oxide semiconductor layer composed by including a second conductivity-type second oxide semiconductor. The same applies hereafter.

Moreover, an insulator layer 18N including an insulating material may be disposed between the solid electrolyte layer 18K and the first oxide semiconductor layer 14.

Moreover, an insulating material may further be contained in the solid electrolyte layer 18K. In the embodiments, a solid electrolyte composed of SiO and an insulating material composed of the SiN, for example, may be contained in the solid electrolyte layer 18K.

Moreover, more solid electrolyte than the insulating material may exist at the second oxide semiconductor layer 24 side of the solid electrolyte layer 18K. More specifically, more solid electrolyte composed of SiO than the insulating material composed of SiN may exist at the second oxide semiconductor layer 24 side of the solid electrolyte layer 18K, for example.

Since the insulator layer 18N is in contact with the solid electrolyte layer 18K in the electricity storage device 30 according to the embodiments, as compared with the electricity storage device 30A according to the comparative example 2, the breakdown voltage is increased.

The solid electrolyte layer 16K can be formed by including SiOₓ, for example. The insulator layer 18N includes plasma-silicon nitride (P-SiN_{y}) (second insulating material) which has a non-hydrous property (no water content) and is not porous, for example. The insulator layer 18N includes a layer with high film density, and has a property that it is hard to contain water as compared with SiOₓ.

A thickness of the SiOₓ is approximately 20 nm to approximately 70 nm, for example.

The insulator layer 18N can be formed by including SiN_{y}, for example. In the embodiments, when the plasma-silicon nitride (P-SiN_{y}) is formed as the SiN_{y}, a thickness thereof is equal to or less than approximately 10 nm, for example. The thickness thereof is more preferably approximately 7 nm to approximately 10 nm, for example.

The first electrode 12 can be formed of a stacked layer of W and Ti or chromium (Cr), and the second electrode 26 can be formed of Al, for example. The first electrode 12 is disposed on a surface which is not opposite to the insulator layer 18N of the first oxide semiconductor layer 14. Moreover, the second electrode 26 is disposed on a surface which is not opposite to the solid electrolyte layer 18K of the second oxide semiconductor layer 24.

The first oxide semiconductor layer 14 can be formed by including a titanium oxide (TiO₂) which is an n type oxide semiconductor, for example.

The second oxide semiconductor layer 24 can be formed by including a nickel oxide (NiO) which is a p type oxide semiconductor. A thickness of the nickel oxide (Ni0) is approximately 200 nm, for example.

As shown in Fig. 3(b), in the charging and discharging characteristics of the electricity storage device according to the embodiments, with respect to voltages V (V₁ to V₅) at the time of charging, the voltage V₅ is changed to 0V at time t₅ after time t₀, and then the voltage V₅ is shifted to a discharged state.

In the case of the electricity storage device 30 according to the embodiments, as shown in Fig. 3(b), for example, reduction of the amount of electricity storage due to degradation of the solid electrolyte layer 18K is observed only after the voltage V at the time of charging becomes equal to or greater than V₅ (e.g., approximately 5.0V). In the case of the electricity storage device 30 according to the embodiments, reduction corresponding to the reduction observed in the case of the single layer silicon oxide (SiOₓ) in the electricity storage device 30A according to the comparative example 2 is observed at 5V.

As shown in Fig. 3(b), the discharging characteristics of the electricity storage device 30 according to the embodiments show substantially flat characteristics to the voltages V (V₁ to V₄) at the time of charging, and show the characteristics that the discharging time decreases only after the voltage V at the time of charging becomes equal to or greater than V₅ (e.g., approximately 5.0V) (In the comparative example 2, the discharging time decreases also when the voltage V at the time of charging is 3V).

According to the electricity storage device 30 according to the embodiments, a larger amount of electricity storage than the electricity storage device according to the comparative example 1 or 2 can be confirmed, also in the case of charging for a long period at the constant current.

According to the electricity storage device 30 according to the embodiments, also in the double layered structure of SiN_{y} / SiOₓ into which the insulator layer 18N is inserted, the increased amount of electricity storage more than the capacitor, and the breakdown voltage at the time of charging can also be improved. A larger amount of the electricity storage than the capacitor also in the charging for a long period at the constant current is confirmed. This is a result of reducing degradation of SiOₓ due to the voltage by using the double layered structure.

Moreover, since the breakdown voltage of the film of SiN_{y} is high, the breakdown voltage is improved by using the double layered structure of SiN_{y} / SiOₓ into which the insulator layer 18N inserted, and the breakdown voltage of whole of the electricity storage device 30 can be improved.

Moreover, SiOₓ can be formed from silicone oil.

Moreover, SiOₓ may be formed from a metal containing silicone.

The solid electrolyte layer 18K may be manufactured by a process including: coating diluted silicone oil on a first oxide semiconductor layer 14; firing the coated silicone oil; and irradiating the fired silicone oil with ultraviolet rays.

Moreover, a manufacturing method of the above-mentioned solid electrolyte layer 18K may include: coating diluted silicone oil; firing the coated silicone oil; and irradiating the fired silicone oil with ultraviolet rays.

According to the embodiments, there can be provided the electricity storage device having the increased electricity storage capacity and improved reliability that can be charged without degradation even when the charging voltage is increased.

### [Other embodiments]

As explained above, the embodiments have been described, as a disclosure including associated description and drawings to be construed as illustrative, not restrictive. This disclosure makes clear a variety of alternative embodiments, working examples, and operational techniques for those skilled in the art.

Such being the case, the embodiments cover a variety of embodiments, whether described or not.

### INDUSTRIAL APPLICABILITY

The electricity storage device of the embodiments can be utilized for various consumer equipment and industrial equipment, and can be applied to wide applicable fields, such as electricity storage devices for system applications capable of transmitting various kinds of sensor information with low power consumption, e.g. communication terminals and electricity storage devices for wireless sensor networks.

### Reference Signs List

12: First electrode (E1)
14: First oxide semiconductor layer (TiO₂ layer)
15N, 18N: Insulator layer
16K, 18K: Solid electrolyte layer
24: Second oxide semiconductor layer (NiO)
26: Second electrode (E2)
30, 30A: Electricity storage device

## Claims

1. An electricity storage device (30) comprising:
a first conductivity-type first oxide semiconductor (14);
an insulator layer (18N) on the first oxide semiconductor layer (14);
a solid electrolyte layer (18K) disposed on the insulator layer (18N), the solid electrolyte layer (18K) including a solid electrolyte enabling proton movement;
a second conductivity-type second oxide semiconductor layer (24) disposed on the solid electrolyte layer (18K);
a first electrode (12) disposed on a surface which is not opposite to the insulator layer (18N) of the first oxide semiconductor layer (14); and
a second electrode (26) disposed on a surface which is not opposite to the solid electrolyte layer (18K) of the second oxide semiconductor layer (24).

2. The electricity storage device according to claim 1, wherein
an insulating material may further be contained in the solid electrolyte layer (18K).

3. The electricity storage device according to claim 2, wherein
a sub layer of the solid electrolyte layer existing near the second oxide semiconductor layer (24) contains more solid electrolytes than the insulating material.

4. The electricity storage device according to any one of claims 1 to 3, wherein
the solid electrolyte layer (18K) contains SiOₓ.

5. The electricity storage device according to claim 1, wherein
the insulator layer (18N) contains SiN_{y}.

6. The electricity storage device according to claim 1 or 5, wherein
a thickness of the insulator layer (18N) is equal to or less than 10 nm.

7. The electricity storage device according to claim 1, 5, or 6, wherein
the insulator layer (18N) comprises plasma-SiN_{y} having a non-hydrous property, the plasma-SiN_{y} being not porous.

8. The electricity storage device according to claim 1 or 2, wherein
the first oxide semiconductor layer (14) contains TiO₂.

9. The electricity storage device according to claim 1 or 2, wherein
the second oxide semiconductor layer (24) contains NiO.

10. The electricity storage device according to claim 4, wherein
the SiOₓ is formed from silicone oil.

11. The electricity storage device according to claim 4, wherein
the SiOₓ is formed from a metal containing silicone.

12. A method for manufacturing the electric storage element according to claim 1 or 2, the method comprising manufacturing the solid electrolyte layer (18K) by a process comprising:
coating diluted silicone oil on the insulator layer (18N) ;
firing the coated silicone oil; and
irradiating the fired silicone oil with ultraviolet rays.

## Patentansprüche

1. Elektrizitätsspeichervorrichtung (30), umfassend:
einen ersten Oxidhalbleiter (14) eines ersten Leitfähigkeitstyps;
eine Isolierschicht (18N) auf der ersten Oxidhalbleiterschicht (14);
eine auf der Isolierschicht (18N) angeordnete Festelektrolytschicht (18K), wobei die Festelektrolytschicht (18K) einen Festelektrolyten aufweist, der Protonenbewegung ermöglicht;
eine zweite Oxidhalbleiterschicht (24) eines zweiten Leitfähigkeitstyps, die auf der Festelektrolytschicht (18K) angeordnet ist;
eine erste Elektrode (12), die auf einer Oberfläche angeordnet ist, welche nicht der Isolierschicht (18N) der ersten Oxidhalbleiterschicht (14) gegenüberliegt; und
eine zweite Elektrode (26), die auf einer Oberfläche angeordnet ist, welche nicht der Festelektrolytschicht (18K) der zweiten Oxidhalbleiterschicht (24) gegenüberliegt.

2. Elektrizitätsspeichervorrichtung nach Anspruch 1, wobei
ein Isoliermaterial ferner in der Festelektrolytschicht (18K) sein kann.

3. Elektrizitätsspeichervorrichtung nach Anspruch 2, wobei
eine in Nähe der zweiten Oxidhalbleiterschicht (24) vorhandene Sub-Schicht der Festelektrolytschicht, die mehr Festelektrolyte als das Isoliermaterial aufweist.

4. Elektrizitätsspeichervorrichtung nach einem der Ansprüche 1 bis 3, wobei
die Festelektrolytschicht (18K) SiOₓ aufweist.

5. Elektrizitätsspeichervorrichtung nach Anspruch 1, wobei
die Isolierschicht (18N) SiN_{y} aufweist.

6. Elektrizitätsspeichervorrichtung nach Anspruch 1 oder 5, wobei
eine Dicke der Isolierschicht (18N) gleich oder weniger als 10 nm beträgt.

7. Elektrizitätsspeichervorrichtung nach Anspruch 1, 5 oder 6, wobei
die Isolierschicht (18N) Plasma-SiN_{y} mit einer nichtwasserhaltigen Eigenschaft umfasst, wobei das Plasma-SiN_{y} nicht porös ist.

8. Elektrizitätsspeichervorrichtung nach Anspruch 1 oder 2, wobei
die erste Oxidhalbleiterschicht (14) TiO₂ aufweist.

9. Elektrizitätsspeichervorrichtung nach Anspruch 1 oder 2, wobei
die zweite Oxidhalbleiterschicht (24) NiO aufweist.

10. Elektrizitätsspeichervorrichtung nach Anspruch 4, wobei
das SiOₓ aus Silikonöl gebildet ist.

11. Elektrizitätsspeichervorrichtung nach Anspruch 4, wobei
das SiOx aus einem metallhaltigen Silikon gebildet ist.

12. Verfahren zur Herstellung des Elektrizitätsspeicherelements nach Anspruch 1 oder 2, wobei das Verfahren ein Herstellen der Festelektrolytschicht (18K) umfasst, durch einen Prozess umfassend:
Auftragen von verdünntem Silikonöl auf die Isolierschicht (18N);
Brennen des aufgetragenen Silikonöls; und
Bestrahlen des gebrannten Silikonöls mit ultravioletten Strahlen.

## Revendications

1. Dispositif de stockage d'électricité (30) comprenant :
un premier semi-conducteur à oxyde (14) de type à première conductivité ;
une couche isolante (18N) sur la première couche semi-conductrice à oxyde (14) ;
une couche d'électrolyte solide (18K) disposée sur la couche isolante (18N), la couche d'électrolyte solide (18K) incluant un électrolyte solide permettant le mouvement de protons ;
une seconde couche semi-conductrice à oxyde (24) de type à seconde conductivité disposée sur la couche d'électrolyte solide (18K) ;
une première électrode (12) disposée sur une surface qui n'est pas opposée à la couche isolante (18N) de la première couche semi-conductrice à oxyde (14) ; et
une seconde électrode (26) disposée sur une surface qui n'est pas opposée à la couche d'électrolyte solide (18K) de la seconde couche semi-conductrice à oxyde (24).

2. Dispositif de stockage d'électricité selon la revendication 1, dans lequel
un matériau isolant peut en outre être contenu dans la couche d'électrolyte solide (18K).

3. Dispositif de stockage d'électricité selon la revendication 2, dans lequel
une sous-couche de la couche d'électrolyte solide présente à proximité de la seconde couche semi-conductrice à oxyde (24) contient plus d'électrolytes solides que le matériau isolant.

4. Dispositif de stockage d'électricité selon l'une quelconque des revendications 1 à 3, dans lequel
la couche d'électrolyte solide (18K) contient du SiOₓ.

5. Dispositif de stockage d'électricité selon la revendication 1, dans lequel
la couche isolante (18N) contient du SiN_{y}.

6. Dispositif de stockage d'électricité selon la revendication 1 ou 5, dans lequel
une épaisseur de la couche isolante (18N) est inférieure ou égale à 10 nm.

7. Dispositif de stockage d'électricité selon la revendication 1, 5 ou 6, dans lequel
la couche isolante (18N) comprend du plasma-SiN_{y} présentant une propriété non aqueuse, le plasma-SiN_{y} étant non poreux.

8. Dispositif de stockage d'électricité selon la revendication 1 ou 2, dans lequel
la première couche semi-conductrice à oxyde (14) contient du TiO₂.

9. Dispositif de stockage d'électricité selon la revendication 1 ou 2, dans lequel
la seconde couche semi-conductrice à oxyde (24) contient du NiO.

10. Dispositif de stockage d'électricité selon la revendication 4, dans lequel
le SiOₓ est formé d'huile de silicone.

11. Dispositif de stockage d'électricité selon la revendication 4, dans lequel
le SiOₓ est formé d'un métal contenant du silicone.

12. Méthode de fabrication de l'élément de stockage électrique selon la revendication 1 ou 2, la méthode comprenant la fabrication de la couche d'électrolyte solide (18K) par un procédé comprenant :
l'enduction de la couche isolante (18N) avec de l'huile de silicone diluée ;
la cuisson de l'huile de silicone appliquée ; et
l'exposition de l'huile de silicone cuite à des rayons ultraviolets.
